(19) Europäisches Patentamt
European Patent Office
Office européen des brevets

(11) **EP 4 548 060 B1**

(12) **EUROPÄISCHE PATENTSCHRIFT**

(45) Veröffentlichungstag und Bekanntmachung des Hinweises auf die Patenterteilung:
**17.09.2025 Patentblatt 2025/38**

(21) Anmeldenummer: **24727628.0**

(22) Anmeldetag: **11.04.2024**

(51) Internationale Patentklassifikation (IPC):
**G01L 1/16** (2006.01)     **G01L 3/10** (2006.01)
**G01L 5/167** (2020.01)     **G01R 31/34** (2020.01)
**G01M 15/02** (2006.01)

(52) Gemeinsame Patentklassifikation (CPC):
**G01L 3/10; G01L 1/16; G01L 5/167; G01M 15/02;**
G01R 31/34

(86) Internationale Anmeldenummer:
**PCT/AT2024/060138**

(87) Internationale Veröffentlichungsnummer:
**WO 2024/211945 (17.10.2024 Gazette 2024/42)**

(54) **MESSANORDNUNG MIT EINER ELEKTRISCHEN MASCHINE UND EINER MESSVORRICHTUNG ZUM BESTIMMEN EINES VERLUSTMOMENTS DER ELEKTRISCHEN MASCHINE**

MEASURING ARRANGEMENT HAVING AN ELECTRIC MACHINE AND HAVING A MEASURING DEVICE FOR DETERMINING A TORQUE LOSS OF THE ELECTRIC MACHINE

SYSTÈME DE MESURE COMPRENANT UNE MACHINE ÉLECTRIQUE ET UN DISPOSITIF DE MESURE POUR DÉTERMINER UN COUPLE DE PERTE DE LA MACHINE ÉLECTRIQUE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **12.04.2023 AT 502672023**

(43) Veröffentlichungstag der Anmeldung:
**07.05.2025 Patentblatt 2025/19**

(73) Patentinhaber:
• **AVL List GmbH**
**8020 Graz (AT)**
• **Piezocryst Advanced Sensorics GmbH**
**8020 Graz (AT)**

(72) Erfinder:
• **WIMLER, David**
**8130 Frohnleiten (AT)**

• **HIRSCHLER, Michael**
**8020 Graz (AT)**
• **SCHRICKER, Alexander**
**8046 Graz (AT)**
• **SCHMIDT, Joachim**
**8042 Werndorf (AT)**
• **NEMETH, Robert**
**8430 Leibnitz (AT)**

(74) Vertreter: **Hartinger, Mario**
**AVL List GmbH**
**Patent Department**
**Hans-List-Platz 1**
**8020 Graz (AT)**

(56) Entgegenhaltungen:
**WO-A1-2019/144172     CN-A- 115 615 597**

**Beschreibung**

Die Erfindung betrifft Messanordnung mit einer elektrischen Maschine mit einem Rotor und einer Messvorrichtung zum Bestimmen eines Verlustmoments der elektrischen Maschine, wobei die Messvorrichtung eine Fixierungseinrichtung und wenigstens ein Piezoelement, bevorzugt wenigstens drei, insbesondere vier, Piezoelemente, mit jeweils einer Vorzugsrichtung aufweist, wobei die Fixierungseinrichtung das wenigstens eine Piezoelement trägt.

Das an einer Elektromaschine in motorischem Betrieb anliegende Widerstands- oder Lastmoment $M_w$ setzt sich zusammen aus einem Antriebsmoment $M_a$ und einem Verlustmoment $M_v$, welches dem Antriebsmoment entgegenwirkt. Das Verlustmoment wird dabei insbesondere durch Luftreibung, durch Lagereibung und, je nach Elektromaschine, durch Bürstenreibung und/oder elektrische Wirbelströme verursacht.

Das Dokument CN 115615597 A zeigt ein Verfahren zum Messen mechanischer Verluste eines Elektromotors. Hierbei wird die Abbremsung des frei drehenden Rotors des Elektromotors über die Zeit modelliert, um das Verlustmoment indirekt zu bestimmen.

Das Dokument WO 2018/046296 A1 offenbart ein Verfahren zum Charakterisieren einer elektromechanischen Aktuatoreinheit, wobei ein Wert für ein Verlustmoment der elektromechanischen Aktuatoreinheit anhand eines Leerlaufstroms, der Differenz zwischen dem ersten Wert und dem zweiten Wert für die in dem Elektromotor induzierte Spannung und der Massenträgheit der elektromechanischen Aktuatoreinheit bestimmt wird.

Aus dem Dokument WO 2019/144171 A1 ist des Weiteren ein Messsystem zur Bestimmung eines Kraft- und/oder eines Drehmoments an einer drehmomentübertragenden Welle bekannt, wobei das Messsystem wenigstens drei, insbesondere wenigstens vier, Piezoelemente mit jeweils einer Vorzugsrichtung aufweist, welche jeweils an unterschiedlichen Positionen um eine Drehachse der Welle in einem Kraftfluss, welcher über die Welle übertragen wird, in der Weise angeordnet sind, dass eine Kraft des Kraftflusses, insbesondere ausschließlich, an den Piezoelementen anliegt, wobei die Vorzugsrichtungen jeweils parallel zu oder in einer einzigen Ebene liegen, welche von der Drehachse geschnitten wird, und wobei die Vorzugsrichtung von wenigstens zweien, insbesondere wenigstens dreien, der Piezoelemente zueinander weder parallel noch antiparallel ausgerichtet sind.

Aus dem Dokument WO 2019/144172 A1 ist des Weiteren eine Messvorrichtung zum Bestimmen einer Kraft und/oder eines Drehmoments an einer drehmomentübertragenden Welle bekannt, welche durch eine Lagervorrichtung, insbesondere an einer Maschine, deren Aus- und/oder Eingangswelle durch die drehmomentübertragende Welle gebildet ist, gelagert ist, wobei die Messvorrichtung wenigstens zwei, vorzugsweise drei oder vier, Piezoelemente in einer Fixierungseinrichtung aufweist, wobei die Fixierungseinrichtung die Piezoelemente trägt und in der Weise ausgebildet ist, dass mittels der Piezoelemente eine Kraft, insbesondere Scherkraft, zwischen der Lagervorrichtung und der Abstützvorrichtung zum Abstützen der Lagervorrichtung messbar ist.

Es ist eine Aufgabe der Erfindung, eine verbesserte Messanordnung zum Bestimmen eines Verlustmoments der elektrischen Maschine bereitzustellen. Insbesondere ist es eine Aufgabe der Erfindung, das Verlustmoment $M_v$ ohne eine Messung von elektrischen Parametern der elektrischen Maschine bestimmen zu können.

Diese Aufgabe wird durch die Lehre der unabhängigen Ansprüche gelöst. Vorteilhafte Ausgestaltungen werden in den abhängigen Ansprüchen beansprucht.

Ein erster Aspekt der Erfindung betrifft eine Messanordnung mit einer elektrischen Maschine mit einem Rotor und einer Messvorrichtung zum Bestimmen eines Verlustmoments der elektrischen Maschine,

wobei die Messvorrichtung eine Fixierungseinrichtung und wenigstens ein Piezoelement, bevorzugt wenigstens drei, insbesondere vier, Piezoelemente, mit jeweils einer Vorzugsrichtung aufweist,

wobei die Fixierungseinrichtung das wenigstens eine Piezoelement trägt und die elektrische Maschine über das wenigstens eine Piezoelement in der Weise lagert, dass mittels des wenigstens einen Piezoelements wenigstens Scherkräfte zwischen der elektrischen Maschine und der Fixierungseinrichtung messbar sind,

wobei die Vorzugsrichtung oder die Vorzugsrichtungen jeweils parallel zu oder in einer einzigen Ebene liegen,

wobei eine Drehachse des Rotors die Ebene in einem Winkel zwischen 45° und 135°, bevorzugt zwischen 85° und 95°, am bevorzugtesten wenigstens im Wesentlichen senkrecht, schneidet, und

wobei der Rotor frei drehend ist.

Ein zweiter Aspekt der Erfindung betrifft ein Verfahren zum Bestimmen eines Verlustmoments einer elektrischen Maschine mit einem Rotor, wobei die elektrische Maschine in der Weise an einer Messvorrichtung gelagert ist, dass ein axiales Drehmoment an der Maschine messbar ist und wobei der Rotor frei drehend ist, die folgenden Arbeitsschritte aufweisend:

- erstes Betreiben der Maschine in der Weise, dass der Rotor eine vordefinierte Drehzahl erreicht;
- zweites Betreiben der Maschine im Leerlauf, wenn die vordefinierte Drehzahl erreicht ist, wobei ein Signal der Messvorrichtung, welches das axiale Moment an der Maschine repräsentiert, überwacht wird;
- Identifizieren eines Sprungs in dem Signal; und
- Bestimmen des Betrags des Sprungs, wobei der Betrag das Verlustmoment der elektrischen Maschine angibt.

Ein dritter Aspekt der Erfindung betrifft einen Prüfstand.

Frei drehend im Sinne der Erfindung bedeutet vorzugsweise nicht von einer externen Last belastet.

Ein Piezoelement in Sinne der Erfindung weist wenigstens einen Piezokristall und Kontakte zu dessen elektrischer Kontaktierung auf. Vorzugsweise ist das Piezoelement als ein Sensor mit weiteren Komponenten wie einem Gehäuse ausgebildet. Weiter vorzugsweise weist ein Piezokrystall einen piezoelektrischen Effekt auf.

Eine Vorzugsrichtung im Sinne der Erfindung gibt an, in welcher Belastungsrichtung des Piezoelements, insbesondere mittels einer Scherkraft auf dessen Stirnfläche, die stärkste Spannung in dem Piezokristall des Piezoelements erzeugt wird. Die Vorzugsrichtung wird auch als Polarisationsrichtung bezeichnet.

Ein axiales Drehmoment im Sinne der Erfindung ist vorzugsweise das an dem Rotor einer Maschine anliegende Drehmoment.

In einem Betrieb im Leerlauf im Sinne der Erfindung bewirkt der Steuerstrom vorzugsweise weder ein Antriebs- noch ein Bremsmoment. Weiter vorzugsweise ist der Steuerstrom abgeschaltet.

Ein Mittel im Sinne der Erfindung kann hard- und/oder softwaretechnisch ausgebildet sein und insbesondere eine, vorzugsweise mit einem Speicher- und/oder Bussystem daten- bzw. signalverbundene, insbesondere digitale, Verarbeitungs-, insbesondere Mikroprozessoreinheit (CPU) und/oder ein oder mehrere Programme oder Programmmodule aufweisen. Die CPU kann dazu ausgebildet sein, Befehle, die als ein in einem Speichersystem abgelegtes Programm implementiert sind, abzuarbeiten, Eingangssignale von einem Datenbus zu erfassen und/oder Ausgangssignale an einen Datenbus abzugeben. Ein Speichersystem kann ein oder mehrere, insbesondere verschiedene, Speichermedien, insbesondere optische, magnetische, Festkörper- und/oder andere nicht-flüchtige Medien, aufweisen. Das Programm kann derart beschaffen sein, dass es die hier beschriebenen Verfahren verkörpert bzw. auszuführen imstande ist, so dass die CPU die Schritte solcher Verfahren ausführen kann.

Die Erfindung beruht auf dem Ansatz, das Verlustmoment einer elektrischen Maschine über ein Reaktionsmoment zum Abstützen der elektrischen Maschine durch ein Nullsetzen des Antriebsmoments $M_a$ der elektrischen Maschine zu bestimmen.

Erfindungsgemäß wird dies dadurch erreicht, indem die Maschine zunächst frei drehend auf eine vordefinierte Drehzahl gebracht wird und dann bei konstant gehaltener Drehzahl abrupt in einen Leerlaufbetrieb der elektrischen Maschine umgeschaltet wird. Infolgedessen ergibt sich ein Sprung in dem an dem Rotor 4 anliegenden Drehmoment, welches dem axialen Reaktionsmoment des Motors entspricht.

Die erfindungsgemäße Messanordnung ermöglicht es, das Verlustmoment einer elektrischen Maschine direkt zu messen, ohne am Rotor eine Last vorsehen zu müssen. Mit anderen Worten wird das Massenträgheitsmoment des Rotors nicht durch eine mit diesem rotierende Messvorrichtung verfälscht. Hierdurch kann das Verlustmoment der elektrischen Maschine wesentlich genauer bestimmt werden.

Auch elektrische Kenngrößen wie induzierte Spannungen und Ströme des Elektromotors müssen erfindungsgemäß nicht gemessen werden, um das Verlustmoment zu bestimmen. Diesbezüglich hat die Erfindung den Vorteil, dass das Verlustmoment durch keine Messung beeinträchtigt werden kann. Darüber hinaus muss kein Verlustmoment aus elektrischen Messungen erst anhand von physikalischen Beziehungen berechnet werden. Auch gegenüber einer solchen Berechnung ist das erfindungsgemäße Verfahren zum Bestimmen des Verlustmoments wesentlich genauer.

Darüber hinaus kann die erfindungsgemäße Messanordnung auf Prüfständen realisiert werden, welche wesentlich einfacher aufgebaut sind als zum Beispiel bei dem Einsatz eines Drehmomentflansches auf Basis von Dehnungsmessstreifen. Auch ist erfindungsgemäß keine Belastungsmaschine notwendig. Darüber hinaus müssen keine Drehzahlrampen gefahren werden.

Der Einsatz von Piezoelementen als Messelemente der Messvorrichtung ermöglich eine besonders genaue Bestimmung des Sprungs in dem Signal. Piezoelemente ermöglichen eine hoch dynamische Messung, so dass diese die Veränderung des Signals von dem Wert vor dem Sprung auf den Wert nach dem Sprung besonders exakt abbilden.

Durch die Lagerung der elektrischen Maschine über das wenigstens eine Piezoelement kann des Weiteren ein Reaktionsmoment auf das axiale Drehmoment gemessen werden, welches am Rotor wirkt - ohne Messungen am Rotor selbst vorzunehmen. Piezoelemente eignen sich hierbei zur Lagerung besonders gut, weil diese eine sehr hohe Steifigkeit und Sensitivität gegenüber hochdynamischen Schwingungen aufweisen.

Grundsätzlich ist es dabei möglich, die elektrische Maschine nur über ein einzelnes Piezoelement abzustützen und weitere Abstützpunkte durch andere Abstützelemente abzustützen. Ein Teil des Kraftflusses verläuft dann jedoch nicht über Piezoelemente, sondern über die anderen Abstützelemente. Daher ist es von Vorteil, mehr Piezoelemente zum Abstützen der elektrischen Maschine einzusetzen. Insbesondere ist es von Vorteil, zwei, drei oder sogar vier Piezoelemente einzusetzen und die elektrische Maschine dann ausschließlich über die Piezoelemente abzustützen, so dass der gesamte von der elektrischen Maschine erzeugte Kraftfluss über die Piezoelemente verläuft. Hierdurch wird eine besonders hohe Messgenauigkeit erreicht.

Erfindungsgemäß liegen die Vorzugsrichtung oder die Vorzugsrichtungen jeweils parallel zu oder in einer einzigen Ebene und die Drehachse des Rotors schneidet die Ebene in einem Winkel zwischen 45° und 135°, bevorzugt zwischen 85° und 95°, am bevorzugtesten wenigstens im Wesentlichen senkrecht. Entsprechend wird der Motor über dessen Stirnseite an der Fixierungseinrichtung abgestützt. Durch diese Anordnung kann das Verlustmoment durch piezoelektrische Scherelemente als Piezoelemente besonders einfach bestimmt werden. Insbesondere können die Messsignale von einzelnen Piezoelementen besonders einfach miteinander zur Bestimmung von Kraftkomponenten verrechnet werden.

Wenigstens im Wesentlichen im Sinne der Erfindung bedeutet in diesem Zusammenhang vorzugsweise einen Winkelbereich von +/- 1°.

In einer vorteilhaften Ausgestaltung der Messanordnung sind die Piezoelemente jeweils an unterschiedlichen Positionen um eine Drehachse des Rotors der elektrischen Maschine angeordnet. Hierdurch kann die elektrische Maschine besonders vorteilhaft auf der Fixierungseinrichtung abgestützt werden, vorzugsweise ohne den Einsatz von weiteren Stützelementen, so dass die elektrische Maschine ausschließlich durch Piezoelemente abgestützt wird.

In einer weiterein vorteilhaften Ausgestaltung der Messanordnung weist die Messvorrichtung des Weiteren eine Vorspanneinrichtung und erste Vorspannelemente auf, wobei das wenigstens eine Piezoelement zwischen der Fixierungseinrichtung und der Vorspanneinrichtung mittels der ersten Vorspannelemente in der Weise vorspannbar oder vorgespannt sind, dass das wenigstens eine Piezoelement kraftschlüssig fixiert ist, und wobei die elektrische Maschine an der Vorspanneinrichtung drehfest befestigt ist.

Das Aufbringen einer Vorspannung mittels einer Vorspanneinrichtung erlaubt, dass auf der Messvorrichtung elektrische Maschinen gewechselt werden können, ohne dass eine Kalibrierung der Messvorrichtung beeinträchtigt wird. Grundsätzlich müssen Piezoelemente vorgespannt werden, um ein gewünschtes lineares Verhalten zu zeigen. Jedes Vorspannen und Entspannen kann jedoch zu einer Änderung im Kraftfluss und somit zu einer Änderung der Kalibrierung der Messvorrichtung führen. Durch die Vorspannvorrichtung muss das System nur einmal vorgespannt werden und die Berechnung kann immer gleichbleiben. Hierdurch können elektrische Maschinen insbesondere schnell gewechselt werden.

Ist keine Vorspanneinrichtung vorhanden, so werden die Piezoelemente direkt zwischen dem Motor 2, insbesondere dessen Gehäuse, und der Fixierungseinrichtung 5 kraftschlüssig fixiert.

In einer weiteren vorteilhaften Ausgestaltung der Messanordnung ist die elektrische Maschine an der Fixierungseinrichtung befestigt und wird von dem wenigstens einen Piezoelement in der Weise abgestützt, dass das wenigstens eine Piezoelement kraftschlüssig fixiert ist.

Hierdurch werden die Piezoelemente in ihrer Position gehalten und eine Kalibrierung beim Wechsel von Maschinen ist nicht notwendig.

In einer weiteren vorteilhaften Ausgestaltung der Messanordnung weist die Fixierungseinrichtung oder die Vorspanneinrichtung eine Aussparung auf, in welcher eine Welle der elektrischen Maschine aufgenommen und/oder hindurchgeführt werden kann, wobei vorzugsweise eine Seite der elektrischen Maschine, auf welcher die Welle austritt, der Fixierungseinrichtung und/oder der Vorspanneinrichtung zugewandt ist.

In einer weiteren vorteilhaften Ausgestaltung der Messanordnung ist die Drehachse bei bestimmungsgemäßem Gebrauch der Messanordnung wenigstens im Wesentlichen vertikal ausgerichtet.

In einer weiteren vorteilhaften Ausgestaltung der Messanordnung werden die Fixierungseinrichtung oder die elektrische Maschine ausschließlich durch das wenigstens eine Piezoelement abgestützt.

Hierdurch verläuft der gesamte relevante Kraftfluss über das oder die Piezoelemente. Dies führt zu einer besonders hohen Messgenauigkeit.

In einer weiteren vorteilhaften Ausgestaltung der Messanordnung ist die Vorzugsrichtung des wenigstens einen Piezoelements jeweils wenigstens im Wesentlichen tangential zu einer Drehrichtung des Rotors ausgerichtet. Auch hierdurch kann eine Berechnung eines Verlustmoments der elektrischen Maschine auf einfache Weise erfolgen.

In einer weiteren vorteilhaften Ausgestaltung der Messanordnung weist das wenigstens eine Piezoelement ein erstes Teilelement und ein zweites Teilelement auf, mittels welchem jeweils Scherkräfte messbar sind, wobei eine Vorzugsrichtung des ersten Teilelements wenigstens im Wesentlichen senkrecht zu einer Vorzugsrichtung des zweiten Teilelements ausgerichtet ist, wobei die Teilelemente jeweils entlang ihrer Stirnseite zueinander angeordnet sind, wobei eine Messung des ersten Teilelements und eine Messung des zweiten Teilelements in Signalen der Messvorrichtung berücksichtigt wird.

Hierdurch ist die Messvorrichtung nicht empfindlich gegenüber einer Ausrichtung der Vorzugsrichtung der beiden Teilelemente. Mit anderen Worten können die beiden Teilelemente, sofern deren relative Ausrichtung nur der definierten entspricht, in beliebiger Weise an der Fixierungseinrichtung angeordnet sein, wobei immer ein volles Messignal zur Verfügung steht. Auf diese Weise wird eine Montage der Messvorrichtung wesentlich vereinfacht und Fehler bei der Bestimmung eines Verlustmoments aufgrund einer Fehlausrichtung eines oder mehrerer Vorzugsrichtungen können vermieden werden.

In einer weiteren vorteilhaften Ausgestaltung der Messanordnung weisen die Piezoelemente ein erstes Teilelement und/oder ein zweites Teilelement, mittels welchem oder welchen eine Scherkraft messbar ist, und ein drittes Teilelement, mittels welchem eine Druckkraft messbar ist, auf, wobei die Teilelemente entlang ihrer Stirnseite zueinander angeordnet sind, wobei eine Messung des ersten Teilelements und/oder des zweiten Teilelements und eine Messung des dritten Teilelements in dem Signal der Messvorrichtung berücksichtigt wird. Durch diese Art der Piezoelemente können sowohl Scherkräfte als auch Druckkräfte gemessen werden

In einer weiteren vorteilhaften Ausgestaltung der Messanordnung weist die Messvorrichtung des Weiteren Mittel auf, welche eingerichtet sind, gewünschte Messgrößen, insbesondere ein Drehmoment um die Drehachse und/oder Kräfte, welche parallel zu der Ebene wirken, unter Berücksichtigung eines jeweiligen Winkels zwischen der Vorzugsrichtung oder den Vorzugsrichtungen des wenigstens einen Piezoelements und Tangenten an die Drehrichtung des Rotors an dem Ort oder den Orten des wenigstens einen Piezoelements zu bestimmen. Durch eine Berücksichtigung der Ausrichtung der Vorzugsrichtung kann das Verlustmoment besonders genau berechnet werden.

In einer weiteren vorteilhaften Ausgestaltung der Messanordnung weist die Messvorrichtung des Weiteren Mittel auf, welche eingerichtet sind, gewünschte Messgrößen, insbesondere ein Drehmoment um die Drehachse und/oder Kräfte, welche parallel zu der Ebene wirken mittels eines, insbesondere linearen, Gleichungssystems anhand von Messungen des wenigstens eine Piezoelements zu bestimmen

Durch die Verwendung eines Gleichungssystems kann das Verlustmoment besonders genau bestimmt werden. Insbesondere müssen die Vorzugsrichtungen der Piezoelemente nicht exakt ausgerichtet sein, da der jeweilige Beitrag der Piezoelemente zu verschiedenen Kraftkomponenten in dem linearen Gleichungssystem berücksichtigt werden kann.

In einer weiteren vorteilhaften Ausgestaltung der Messanordnung weist die Fixierungseinrichtung Ausnehmungen auf, in welchen jeweils ein Piezoelement angeordnet ist. Hierdurch kann die Messvorrichtung besonders kompakt gestaltet werden. Darüber hinaus sind die Piezoelemente geschützt, da die Ausnehmung wie ein Gehäuse wirkt.

In einer weiteren vorteilhaften Ausgestaltung der Messanordnung sind die Fixierungseinrichtung und die Vorspanneinrichtung zweiteilig ausgebildet und die Vorspanneinrichtung weist zwei Halbschalen auf, um die elektrische Maschine aufzunehmen, wobei die Messvorrichtung des Weiteren zwei Vorspannelemente aufweist, mittels welcher die beiden Halbschalen gegeneinander vorgespannt werden können, so dass zwischen der Vorspanneinrichtung und der elektrischen Maschine ein Kraftschluss herstellbar ist.

Hierdurch kann die elektrische Maschine besonders einfach an der Messvorrichtung befestigt werden. Insbesondere sind keine Befestigungsmittel wie Schrauben oder Montagelöcher an einem Gehäuse der elektrischen Maschine notwendig.

In einer weiteren vorteilhaften Ausgestaltung der Messanordnung ist die Fixierungseinrichtung als Fixierplatte, insbesondere Grundplatte, ausgebildet ist, welche bei bestimmungsgemäßem Gebrauch auf einem Prüfstand montiert ist, und/oder die Vorspanneinrichtung ist eine Vorspannplatte. Platten sind besonders gut zum Abstützen der Piezoelemente geeignet.

Weitere Vorteile und Merkmale ergeben sich aus der nachfolgenden Beschreibung in Zusammenhang mit den Figuren. Es zeigen wenigstens teilweise schematisch:

Figur 1     Eine teilweise transparente Draufsicht eines ersten Ausführungsbeispiels einer Messanordnung zum Bestimmen eines Verlustmoments einer elektrischen Maschine;

Figur 2     eine teilweise transparente Seitenansicht der Messanordnung gemäß Figur 1;

Figur 3     eine teilweise transparente Draufsicht eines zweiten Ausführungsbeispiels der Messanordnung zum Bestimmen eines Verlustmoments einer elektrischen Maschine;

Figur 4     eine teilweise transparente Draufsicht eines dritten Ausführungsbeispiels der Messanordnung zum Bestimmen eines Verlustmoments einer elektrischen Maschine;

Figur 5     eine teilweise transparente Seitenansicht der Messanordnung gemäß Figur 4;

Figur 6     eine alternative Ausführungsform eines Piezoelements;

Figur 7     eine weitere alternative Ausführungsform eines Piezoelements;

Figur 8     ein Diagramm, welches den zeitlichen Verlauf der Winkelgeschwindigkeit des Rotors, des an dem Rotor anliegenden Drehmoments und des Steuerstroms in Abhängigkeit von der Zeit zeigt;

Figur 9     ein weiteres Diagramm, welches den Steuerstrom und das an dem Rotor anliegende Drehmoment $M_z$ nochmals in Abhängigkeit der Zeit darstellt;

Figur 10     ein Blockdiagramm eines Verfahrens zum Bestimmen eines Verlustmoments einer elektrischen Maschine; und

**Figur 11**   ein Ausführungsbeispiel eines Systems zum Bestimmen eines Verlustmoments.

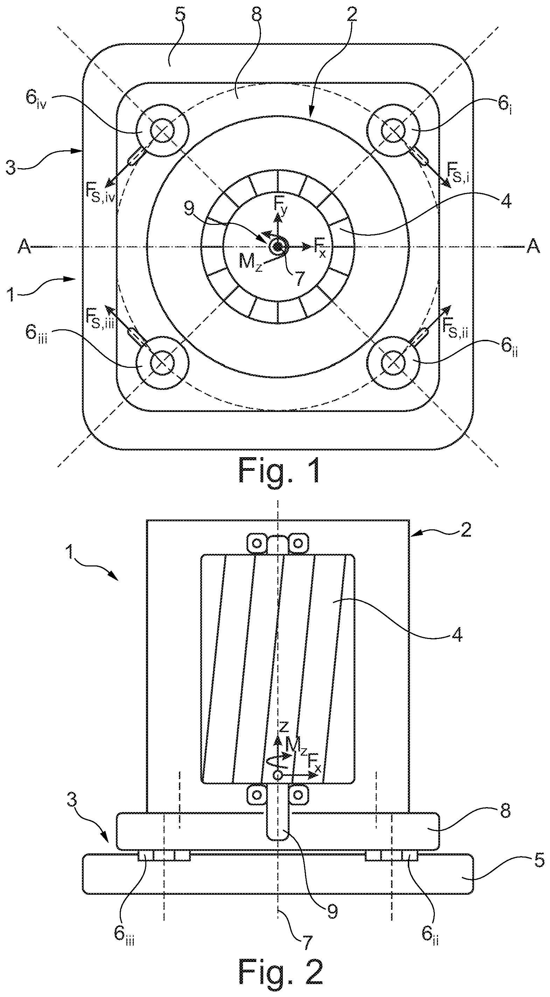

Anhand der **Figuren 1 und 2** wird ein erstes Ausführungsbeispiel einer Messanordnung 1 zum Bestimmen eines Verlustmoments einer elektrischen Maschine 2 erläutert. Figur 2 ist hierbei eine teilweise transparente Seitenansicht der Messanordnung 3 aus Figur 1.

Bei der elektrischen Maschine 2 handelt es sich vorzugsweise um einen Motor mit rotierender Welle 9, welche einen Rotor 4 aufweist, welcher sich auf der rotierenden Welle 9 um eine Drehachse 7 dreht.

Die Messanordnung 1 weist zur Messung von Momenten eine Messvorrichtung 3 auf. Die Messvorrichtung 3 weist eine Fixierungseinrichtung 5 und vorzugsweise eine Vorspanneinrichtung 8 auf. Zwischen der Fixierungseinrichtung 5 und der Vorspanneinrichtung 8 sind Piezoelemente 6i, 6ii, 6iii und 6iv angeordnet, welche mittels Vorspannelementen, insbesondere Schrauben (nicht dargestellt) fixiert und vorgespannt werden. Bei den Piezoelementen 6i bis 6iv handelt es sich um piezoelektrische Messelemente, welche den piezoelektrischen Schereffekt ausnutzen. Dies bedeutet, dass die Piezoelemente Scherkräfte $F_{S,i}$ bis $F_{S,iv}$ messen, die in einer Ebene wirken, in welcher die Piezoelemente 6i bis 6iv angeordnet sind.

Der Motor 2 ist in dem in den Figuren 1 und 2 gezeigten Ausführungsbeispiel auf der Vorspanneinrichtung 8 drehfest befestigt. Mithin werden Drehmomente, welche auf die Welle 9 bzw. den Rotor 4 wirken, über das Gehäuse des Motors 2 auf die Vorspannrichtung 8 übertragen. Die Fixierungseinrichtung 5 ist vorzugsweise drehfest gelagert, so dass diese Momente an den Piezoelementen 6i bis 6iv die Scherkräfte $F_{S,i}$ bis $F_{S,iv}$ hervorrufen.

Der elektrische Motor 2 ist frei hängend. Dies bedeutet, dass der Rotor 4 frei drehend ist, d.h. nicht von einer externen Last belastet ist. Dies ist allen Ausführungsbeispiele der Messanordnung 1 gemein.

Wie aus Figur 2 ersichtlich, sind die Messelemente 6i bis 6iv wenigstens teilweise in Ausnehmungen der Fixierplatte 5 aufgenommen.

Vorzugsweise weist die Vorspanneinrichtung 8, welche in Figur 2 als Vorspannplatte ausgebildet ist, eine Aussparung auf, durch welche die Welle 9 des Motors 2 geführt werden kann. Weiter vorzugsweise weist auch die Fixiereinrichtung 5, welche in Figur 2 als Fixierplatte ausgebildet ist, eine solche Aussparung auf.

Die Kraftkomponenten, welche durch die Piezoelemente 6i bis 6iv gemessen werden, sind in Figur 1 eingezeichnet. Dies sind die Kraftkomponente in Y-Richtung $F_y$, die Kraftkomponente in X-Richtung $F_x$ und das axiale Drehmoment um die Drehachse 7 $M_z$. Wie in Figur 1 gezeigt, sind Vorzugsrichtungen der Piezoelemente, angegeben durch die Vektorpfeile $F_{S,i}$ bis $F_{S,iv}$ der gemessenen Scherkräfte, tangential an eine Drehrichtung des Rotors 4 um die Drehachse 7 ausgerichtet.

In diesem Fall kann das axiale Drehmoment $M_z$,

welches an dem Motor 2 anliegt, einfach durch folgende Gleichung berechnet werden:

$$M_z = (-F_{S,i} + F_{S,ii} - F_{S,iii} + F_{S,iv}) * R$$

wobei R der Abstand der Piezoelemente 6i bis 6iv von der Drehachse 7 des Rotors 4 ist.

Die Vorzeichen vor den gemessenen Scherkräften ergeben sich aus der jeweiligen Ausrichtung der Vorzugsrichtung der Piezoelemente 6i bis 6iv. Die gemessenen Scherkräfte $F_{S,i}$ bis $F_{S,iv}$ errechnen sich hierbei aus den Messsignalen $S_i$, $S_{ii}$, $S_{iii}$, $S_{iv}$, welche vorzugsweise in Pikocoulomb angegeben sind und einer jeweiligen Sensorempfindlichkeit, welche vorzugsweise in N/pC angegeben ist.

In der obigen Gleichung spielt der jeweilige Winkel $\beta$ zwischen den Vorzugsrichtungen der Piezoelemente 6i bis 6iv und der jeweiligen Tangente an dem Ort des Piezoelements 6i bis 6iv an die Drehrichtung des Rotors 4 eine wichtige Rolle. Durch diesen Winkel $\beta$ wird vorgegeben, welcher Anteil einer gemessenen Scherkraft $F_S$ der tangentialen Richtung und damit dem Drehmoment $M_z$ zuzurechnen sind.

Hierbei ergibt sich die Tangentialkraft $F_t$ aus der Scherkraft $F_S$ gemäß folgender Gleichung:

$$F_t = F_S \cdot \cos \beta$$

In dem in den Figuren 1 und 2 gezeigten ersten Ausführungsbeispiel der Messanordnung 1 ist der Winkel $\beta = 0°$ für die Piezoelemente 6ii und 6iv und $\beta = 180°$ für die Piezoelemente 6i und 6iii. Die einzelnen Piezoelemente 6i bis 6iv können aber auch beliebig gelegt werden. Hierdurch wird, wie oben beschrieben, nicht die gesamte Kraft in tangentialer Richtung gemessen, sondern nur eine anteilige Kraft $F_t$ gemäß obiger Gleichung. Um das Drehmoment $M_z$ gemäß der oben angegebenen Gleichung berechnen zu können, muss der gemessene tangentiale Anteil der Kraft F mit einem Gewichtungsfaktor wieder auf 100 % errechnet werden. Beispielsweise würde für $\beta = 45°$ $F_t = 0,707 - F_S$ sein. Daher müsste die gemessene tangentiale Kraft $F_t$ mit 1,293 multipliziert werden, um fehlende Signalkomponenten zu kompensieren.

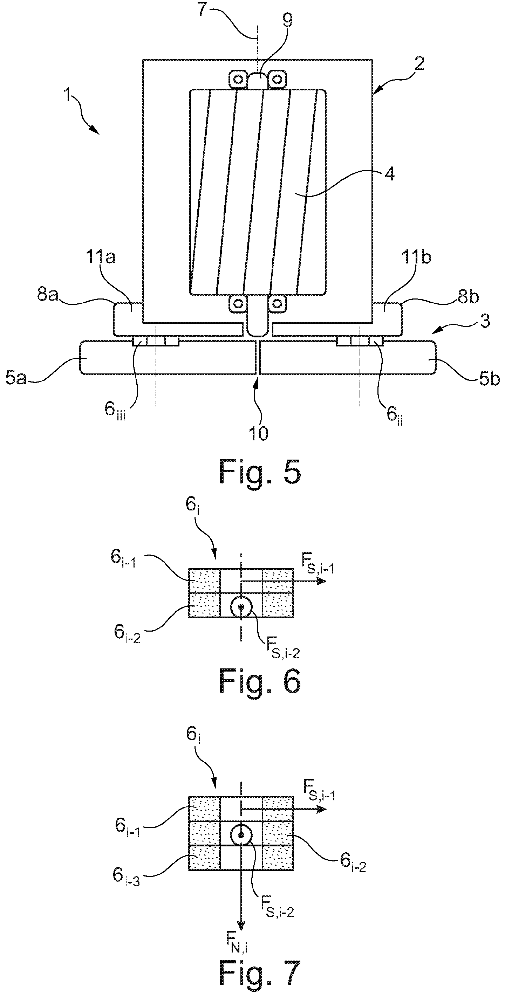

Um stets ein volles Messsignal zur Verfügung zu haben, können auch Piezoelemente 6i zum Einsatz kommen, welche zwei Teilelemente 6i-1, 6i-2 aufweist, welche an ihren Stirnseiten aneinander anliegend angeordnet sind. Hierfür sollte die Vorzugsrichtung der einzelnen Teilelemente 6i-1, 6i-2 eine senkrechte Ausrichtung, wie in **Figur 6** durch die eingezeichneten Vektoren der messbaren Scherkräfte $F_{Si-1}$, $F_{Si-2}$ angedeutet ist. Der Betrag der Scherkraft in tangentialer Richtung ergibt sich hierbei aus der projizierten Länge des Summenvektors auf die tangentiale Richtung.

Diese Ausgestaltung der Piezoelements 6i bis 6iv erzeugt also stets ein Messsignal Si, das jenem eines einzelnen Piezoelements entspricht, dessen Vorzugsrichtung in tangentialer Richtung zur Drehrichtung des Rotors 4 ausgerichtet wäre.

Alternativ zu der oben genannten Gleichung zur Berechnung des Drehmoments $M_z$ kann zur Berechnung der Kraftkomponenten $F_x$, $F_y$ und der Drehmomentkomponente $M_z$ in der Ebene, welche durch die Lage der Piezoelemente 6i, 6ii, 6iii, 6iv gebildet wird, auch ein, insbesondere lineares, Gleichungssystem zum Einsatz kommen. Das lineare Gleichungssystem kann in einer Matrixschreibweise zusammengefasst und wie folgt dargestellt werden:

$$\begin{pmatrix} Mz \\ Fx \\ Fy \end{pmatrix} = \begin{pmatrix} C1i & \cdots & C1iv \\ \vdots & \ddots & \vdots \\ C3i & \cdots & C3iv \end{pmatrix} \begin{pmatrix} Si \\ Sii \\ Siii \\ Siv \end{pmatrix}$$

Die einzelnen Koeffizienten der Matrix können durch Kalibrationsmessungen mittels der Messvorrichtung 3 bestimmt werden, welche vorzugsweise nach erfolgter Vorspannung der Piezoelemente 6i bis 6iv durchgeführt werden.

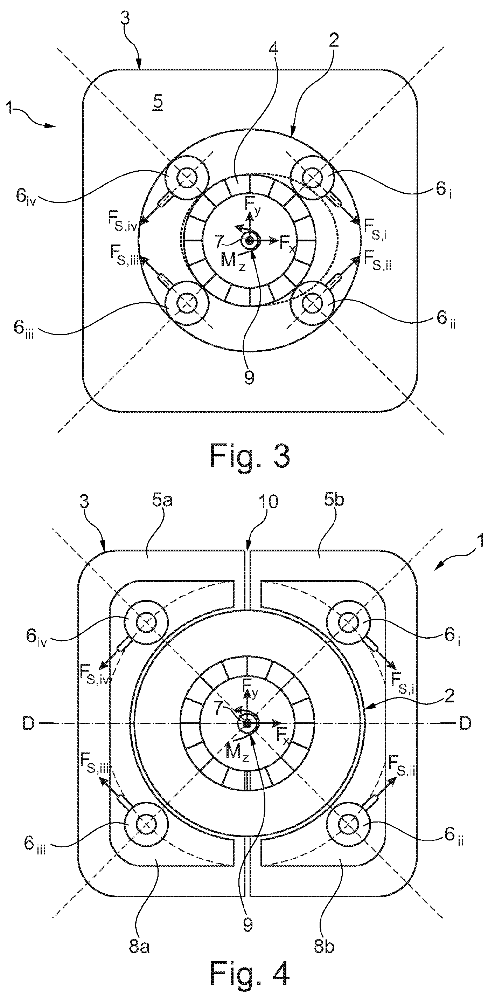

**Figur 3** zeigt ein zweites Ausführungsbeispiel einer Messanordnung 1. In Unterschied zu dem ersten Ausführungsbeispiel der Messanordnung 1 weist das zweite Ausführungsbeispiel lediglich die Fixierungseinrichtung 5 auf, welche als Fixierplatte ausgebildet ist.

Eine Vorspanneinrichtung in Form einer weiteren Platte ist bei dem zweiten Ausführungsbeispiel nicht vorhanden. Dafür wird ein Gehäuse des Motors bzw. der Motor 2 direkt auf den Piezoelementen 6i bis 6iv angeordnet. Das Gehäuse des Motors bzw. der Motor 2 wird hierbei in der Weise mit der Fixierplatte 5 vorgespannt, dass sich ein Kraftschluss zwischen dem Gehäuse des Motors bzw. dem Motor 2 selbst einerseits und zwischen den Piezoelementen 6i bis 6iv und der Fixierplatte 5 andererseits ausbildet. Auf diese Weise können auch in diesem Ausführungsbeispiel Scherkräfte in die Piezoelemente 6i bis 6iv aufgebracht werden.

Ein drittes Ausführungsbeispiel einer Messanordnung zum Bestimmen eines Verlustmoments einer elektrischen Maschine wird in Bezug auf die **Figuren 4 und 5** erläutert:

In diesem Ausführungsbeispiel sind sowohl die Fixiereinrichtungen 5a, 5b als auch die Vorspanneinrichtung 8a, 8b zweiteilig ausgeführt. Die Fixiereinrichtung weist eine erste Fixierplatte 5a und eine zweite Fixierplatte 5b auf, welche durch einen Spalt 10 voneinander beabstandet sind. Die Vorspanneinrichtung weist eine erste Halbschale 8a und eine zweite Halbschale 8b auf. Die erste Halbschale 8a ist über zwei Piezoelemente 6iii, 6iv an der ersten Fixierplatte 5a angeordnet und mittels Vorspannelementen (nicht dargestellt) an der ersten Fixierplatte 5a befestigt. Auch die zweite Halbschale 8b ist über zwei Piezoelemente 6i, 6ii auf der zweiten Fixierplatte 5b angeordnet. Auch diese sind mit Spannelementen (nicht dargestellt) aneinander befestigt, so dass über einen Kraftschluss Scherkräfte auf die Piezoelemente 6i, 6ii eingeleitet werden können.

**Figur 5** zeigt eine seitliche Ansicht der Messanordnung 1 gemäß Figur 4. Wie aus Figur 5 hervorgeht, kann der Motor 2 mittels der beiden Halbschalen 8a, 8b fixiert werden.

Die Halbschalen 8a, 8b sind vorzugsweise so ausgebildet, dass diese den Elektromotor 2 durch einen Kraftschluss fixieren können. Hierfür weisen die Halbschalen 8a, 8b jeweils einen Absatz 11a, 11b auf, mittels welchem der Motor 2 geklemmt werden kann. Zum Klemmen weist die Messvorrichtung 3 vorzugsweise weitere Spannmittel (nicht dargestellt) auf, mit welchen die erste Fixierplatte 5a und die zweite Fixierplatte 5b und damit auch die erste Halbschale 8a und die zweite Halbschale 8b gegeneinander vorgespannt werden können. Auch diese Spannelemente sind vorzugsweise als Schraubmittel ausgebildet.

Ein Spalt (kein Bezugszeichen) zwischen den beiden Halbschalen 8a, 8b, aber auch der Spalt 10 zwischen der ersten Fixierplatte 5a und der zweiten Fixierplatte 5b kann dabei so ausgebildet sein, dass auch hier die Welle 9 aufgenommen werden kann.

Den in den Figuren 1 bis 5 gezeigten drei Ausführungsbeispielen ist gemein, dass der Motor 2 mit einer seiner Stirnseiten an der Messvorrichtung 3 angeordnet ist. Das erfindungsgemäße Messprinzip, welches weiter unten erläutert wird, funktioniert jedoch auch, wenn der Motor 2 mit der anderen Stirnseite zu der Messvorrichtung 3 hin angeordnet ist.

Die Vorspanneinrichtung 8 kann auch als motorspezifische Adapterplatte ausgebildet sein. Weiterhin können weitere Platten auf der Vorspannplatte 8 montiert werden, welche als motorspezifische Adapterplatten ausgebildet sind. Hierdurch können Rüstzeiten für die Messanordnung 1, in welcher der Motor 2 auf der Messvorrichtung installiert wird, verringert werden.

Auch wenn in Bezug auf alle drei Ausführungsbeispiele der Figuren 1 bis 5 dargestellt ist, dass die Drehachse 7 des Rotors 4 senkrecht zu einer von den Piezoelementen 6i bis 6iv bzw. deren Vorzugsrichtungen aufgespannten Ebene ausgerichtet ist, kann die Drehachse 7 auch schräg zu dieser Ebene ausgerichtet sein, solange diese die aufgespannte Ebene schneidet. Vorzugsweise schneidet die Drehachse 7 die Ebene in einem Winkel zwischen 45° und 135°. Ist die Drehachse nicht senkrecht zu der Ebene ausgerichtet, so muss die Ausrichtung bei der oben genannten Gleichung zur Berechnung des Drehmoments $M_z$ durch entsprechende geometrische Faktoren berücksichtigt werden. Entsprechend macht eine Schrägstellung der Drehachse 7 in Bezug auf die genannte Ebene auch eine Neubestimmung der Koeffizienten der Kalibrationsmatrix bzw. der Koeffizienten des oben genannten Gleichungssystems notwendig.

Um auch eine Normalkraft $F_{N,i}$ zu messen, kann vorgesehen sein, zusätzlich zu zwei übereinander liegenden Teilelementen 6ii-1, 6ii-2; 6iii-1, 6iii-2; 6i-1, 6i-2;

6iv-1, 6iv-2, dritte Teileelemente 6ii-3, 6iii-3, 6i-3, 6iv-3 vorgesehen sind, wie dies in **Figur 7** dargestellt ist. Dabei müssen die jeweils übereinander liegenden Teileelemente 6ii-1, 6ii-2; 6iii-1, 6iii-2; 6i-1, 6i-2; 6iv-1, 6iv-2 Vorzugsrichtungen aufweisen, die in einem rechten Winkel zueinander angeordnet sind.

Auch in diesem Fall ergibt sich die Scherkraft $F_t$ in tangentialer Richtung an die Drehrichtung des Rotors 4 aus der projizierten Länge des Summenvektors auf die tangentiale Richtung.

Bei allen gezeigten Ausführungsbeispielen der Messanordnung kann eine beliebige Anzahl an Piezoelementen 6i bis 6iv verbaut werden. Grundsätzlich ist aber zu beachten, dass die Vorspannplatte und/oder der elektrische Motor 2 an wenigstens drei Positionen abgestützt werden müssen, um eine stabile Lage zu erreichen. Aus diesem Grund muss bei weniger als drei Piezoelementen 6i bis 6iv noch jeweils ein oder zwei weitere Aufstandselemente vorgesehen sein. Diese führen allerdings zu Kraftnebenschlüssen, was die Messgenauigkeit der Messvorrichtung 2 verschlechtert. Insbesondere verringern diese anteilig den Kraftfluss über das vorhandene Piezoelement oder die vorhandenen Piezoelemente 6i bis 6iv. Darüber hinaus können die weiteren Abstützelemente zu Nichtlinearitäten führen.

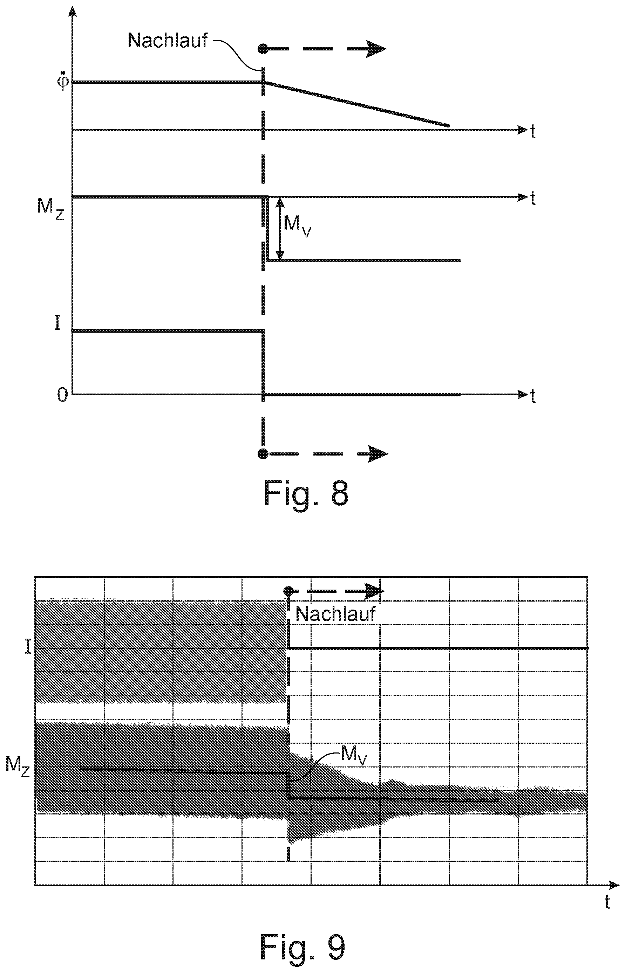

Anhand der **Figuren 8 bis 10** wird nachfolgend ein Ausführungsbeispiel eines Verfahrens zur Bestimmung eines Verlustmoments einer elektrischen Maschine 2 mit Rotor 4 beschrieben.

Bei diesem Verfahren kommen Messanordnungen zum Einsatz, wie sie in Bezug auf die Figuren 1 bis 7 beschrieben wurden.

Wie eingangs beschrieben, wird der Rotor 4 eines Elektromotors 2 durch die Wechselwirkung in einem Magnetfeld beschleunigt. Dabei wird das Antriebs-moment $M_a$ aufgebracht. Gleichzeitig wirken diesem An-triebsmoment $M_a$ Verlustmomente $M_v$ entgegen.

Wird der Rotor 4 beschleunigt, so wirkt der Beschleunigung ein Moment entgegen, welches durch das Massenträgheitsmoment J des Rotors 4 erzeugt wird. Hierbei gilt

$$M_z = J\ddot\varphi :$$

$$M_z = M_a - M_v = J\ddot\varphi$$

Entsprechend der Gleichung kann bei einem Beschleunigungsvorgang oder einem Bremsvorgang des Rotors 4 das Antriebsmoment $M_a$ nicht von dem Verlustmoment $M_v$ unterschieden werden.

Bei konstanter Winkelgeschwindigkeit ($\ddot\varphi = 0$) gilt entsprechend:

$$M_a - M_v = 0$$

Wird nun der Motor 2 im Leerlauf betrieben, so dass der Rotor 4 ausläuft, ein sogenannter "Coast-down"-Betrieb, so wird das Antriebsmoment $M_a = 0$. Entsprechend gilt dann für das gemessene axiale Dreh-moment $M_z = - M_v$.

Der Leerlaufbetrieb kann dadurch erreicht werden, dass der Motor stromlos gestellt bzw. der Steuerstrom unterbrochen wird.

Entsprechend reagiert das axiale Drehmoment $M_z$ des Rotors 4 mit einer Sprungantwort, weil in dem Moment des Beginns des Leerlaufbetriebs nur noch das Verlustmoment $M_v$ anliegt. Diese Sprungantwort ist ebenfalls in dem Diagramm von Figur 8 dargestellt, des Weiteren auch der Verlauf des Steuerstroms I gegenüber der Zeit.

Die Sprungantwort des axialen Drehmoments $M_z$ kann als Reaktionsmoment an dem Motor 2 gemessen werden, insbesondere mittels einem der gezeigten Ausführungsbeispiele einer Messanordnung 1.

In dem Moment, in dem das Antriebsmoment $M_a$ Null wird, fängt die Drehgeschwindigkeit $\dot\varphi$ des Rotors 4 an, sich zu verringern, wie in dem Diagramm gemäß Figur 8 dargestellt.

Der Einsatz von Piezoelementen eignet sich besonders gut für diese Messung, da Piezoelemente besonders gut dynamische Kräfte messen können.

Figur 9 zeigt ein weiteres Diagramm, in welchem reale Messungen des Steuerstroms I und des axialen Drehmoments $M_z$ einer realen Messung an einer Messanordnung 1 gemäß dem ersten Ausführungsbeispiel dargestellt sind.

Das gemessene Bremsmoment $M_v$ ist 0,5 Nm. Der in dem Diagramm als Steuerstrom I dargestellte Bereich entspricht drei periodischen Phasenströmen von Amplituden mit zirka 40 A. Diese gehen zum Zeitpunkt des Coast-down auf 0. Das Signal des axialen Drehmoments $M_z$ ist mittels eines Tiefpasses bei zirka 500 Hz gefiltert. Die Sprungantwort des axialen Drehmoments $M_z$ ergibt sich aus den als Linien eingezeichneten linearen Fits des Drehmomentsignals $M_z$ vor und nach dem Coast-down. Ein Blockdiagramm des Ausführungsbeispiels Verfahrens 100 zum Bestimmen eines Verlustmoments einer elektrischen Maschine 2 mit rotierender Welle 4 ist in Figur 8 dargestellt.

Wie bereits im Vorhergehenden erläutert, ist der elektrische Motor 2 frei drehend auf der Messvorrichtung 1 aufgenommen und insbesondere ist mit dem frei drehenden Rotor 4 bzw. dessen Welle 9 keine Belastungsmaschine verbunden.

In einem ersten Arbeitsschritt 101 wird der Motor 2 mittels eines Steuerstroms I in der Weise betrieben, dass der Rotor 4 eine vordefinierte Drehzahl erreicht. Der Motor 2 wird hierbei eigenständig, d.h. durch das in dem Motor 2 erzeugte Beschleunigungsmoment $M_a$ auf die vordefinierte Drehzahl beschleunigt.

Als Steuerströme kommen vorzugsweise dreiphasige sinusförmige Ströme zum Einsatz, in Abhängigkeit der Art von Motor 2.

Nachdem die vordefinierte Drehzahl erreicht ist, wird der Motor 2 vorzugsweise mit konstanter Drehzahl weiter betrieben.

In einem zweiten Arbeitsschritt 102 wird der Motor 2 dann im Leerlauf betrieben. Vorzugsweise wird hierfür der Steuerstrom I abgeschaltet, insbesondere unterbrochen. Vorzugsweise kommt hierfür ein Schalter oder Relais zum Einsatz.

In einem dritten Arbeitsschritt 103 wird das Signal mittels eines Tiefpassfilters, welcher vorzugsweise eine Grenzfrequenz von 500 Hz aufweist, gefiltert. Hierdurch kann ein niederfrequentes Signal aus einem hochdynamischen Messsignal, wie es beispielsweise von Piezoelementen 6i bis 6iv erzeugt wird, erkannt werden.

In einem vierten Arbeitsschritt 104 wird ein Sprung in dem gefilterten Signal identifiziert.

In Abhängigkeit der Position des Sprungs wird das Signal in einem ersten Abschnitt vor dem identifizierten Sprung und in einem zweiten Abschnitt nach dem Sprung in einem fünften Arbeitsschritt 105 jeweils gefittet.

Auf der Grundlage der vor dem Sprung und nach dem Sprung gefitteten Signalabschnitte wird in einem sechsten Arbeitsschritt 106 der Betrag des Sprungs bestimmt. Dieser Betrag des Sprungs entspricht dem axialen Drehmoment $M_z$ des Rotors 4 zum Zeitpunkt des Coast-down, d.h. des Umschaltens des Motors 2 in den Leerlaufbetrieb, und mithin dem negativen Verlustmoment $M_v$ in diesem Moment. Vorzugsweise wird das Verlustmoment $M_v$ an eine Schnittstelle ausgegeben.

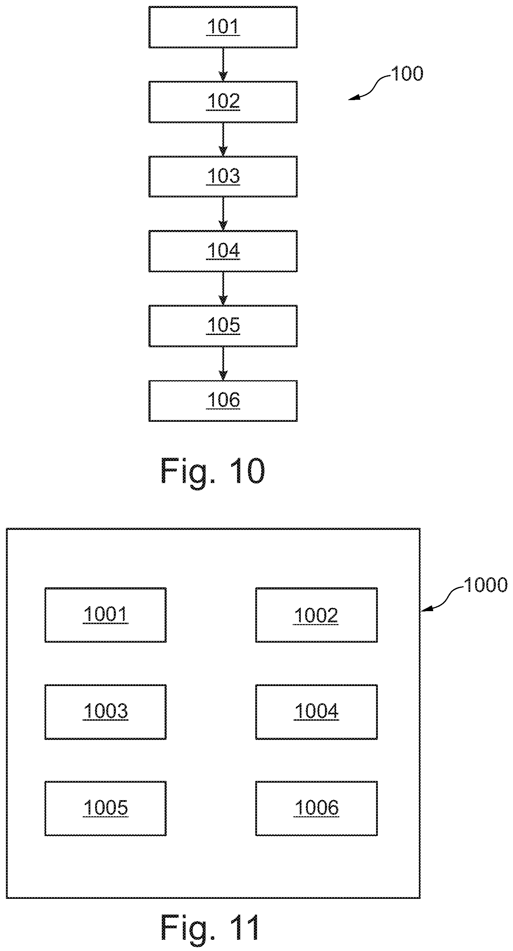

**Figur 11** zeigt ein Modul 1000 zum Bestimmen eines Verlustmoments einer Messvorrichtung 3, insbesondere mittels einem der Ausführungsbeispiele der Messanordnungen 1.

Das Modul 1000 weist Mittel 1001 zum Steuern eines Betriebs der Maschine 2 auf, eingerichtet, um die Maschine 2 zunächst in der Weise zu betreiben, dass der Rotor 4 eine vordefinierte Drehzahl erreicht, und um die Maschine danach im Leerlauf zu betreiben. Des Weiteren weist das Modul 1000 Mittel 1002 zum Überwachen eines Signals der Messvorrichtung 3, welches das axiale Moment an der Maschine 2 repräsentiert, auf. Des Weiteren weist das Modul 1000 Mittel 1004 zum Identifizieren eines Sprungs in dem Signal und Mittel 1006 zum Bestimmen des Betrags des Sprungs, wobei der Betrag das Verlustmoment der elektrischen Maschine 2 angibt. Weitere, optionale Mittel 1003 zum Filtern des Signals und Mittel 1005 zum Fitten des Signals können vorhanden sein.

Es wird darauf hingewiesen, dass es sich bei den Ausführungsbeispielen lediglich um Beispiele handelt, die den Schutzbereich, die Anwendungen und den Aufbau in keiner Weise einschränken. Vielmehr wird dem Fachmann durch die vorausgehende Beschreibung ein Leitfaden für die Umsetzung mindestens eines Ausführungsbeispiels gegeben, wobei diverse Änderungen, insbesondere im Hinblick auf die Funktion und Anordnung der beschriebenen Bestandteile, vorgenommen werden können, ohne den Schutzbereich zu verlassen, wie er sich aus den Ansprüchen ergibt.

**Patentansprüche**

1. Messanordnung (1) mit einer elektrischen Maschine (2) mit einem Rotor (4) und einer Messvorrichtung (3) zum Bestimmen eines Verlustmoments der elektrischen Maschine (2), wobei der Rotor (4) frei drehend und daher nicht von einer externen Last belastet ist, **dadurch gekennzeichnet, dass**

   die Messvorrichtung (3) eine Fixierungseinrichtung (5) und wenigstens ein Piezoelement (6i, 6ii, 6iii, 6iv), bevorzugt wenigstens drei, insbesondere vier, Piezoelemente, mit jeweils einer Vorzugsrichtung aufweist,
   wobei die Fixierungseinrichtung (5) das wenigstens eine Piezoelement (6i, 6ii, 6iii, 6iv) trägt und die elektrische Maschine über das wenigstens eine Piezoelement (6i, 6ii, 6iii, 6iv) in der Weise lagert, dass mittels des wenigstens einen Piezoelements (6i, 6ii, 6iii, 6iv) wenigstens Scherkräfte zwischen der elektrischen Maschine (2) und der Fixierungseinrichtung (5) messbar sind,
   wobei die Vorzugsrichtung oder die Vorzugsrichtungen jeweils parallel zu oder in einer einzigen Ebene liegen,
   wobei eine Drehachse (7) des Rotors (4) die Ebene in einem Winkel zwischen 45° und 135°, bevorzugt zwischen 85° und 95°, am bevorzugtesten wenigstens im Wesentlichen senkrecht, schneidet.

2. Messanordnung (1) nach Anspruch 1, wobei die Messvorrichtung (3) mehr als ein Piezoelement (6i, 6ii, 6iii, 6iv) aufweist, wobei die Piezoelemente (6i, 6ii, 6iii, 6iv) jeweils an unterschiedlichen Positionen um die Drehachse (7) des Rotors (4) der elektrischen Maschine (2) angeordnet sind.

3. Messanordnung (1) nach Anspruch 1 oder 2, wobei die Messvorrichtung (2) des Weiteren eine Vorspanneinrichtung (8) und erste Vorspannelemente aufweist, wobei das wenigstens eine Piezoelement (6i, 6ii, 6iii, 6iv) zwischen der Fixierungseinrichtung (5) und der Vorspanneinrichtung (8) mittels der ersten Vorspannelemente in der Weise vorspannbar oder vorgespannt ist, dass das wenigstens eine Piezoelement (6i, 6ii, 6iii, 6iv) kraftschlüssig fixiert ist, und wobei die elektrische Maschine (2) an der Vorspanneinrichtung (8) drehfest befestigt ist.

4. Messanordnung (1) nach einem der Ansprüche 1 bis 3, wobei die elektrische Maschine (2) an der Fixierungseinrichtung (5) befestigt ist und von dem wenigstens einen Piezoelement (6i, 6ii, 6iii, 6iv) in der Weise abgestützt wird, dass das wenigstens eine Piezoelement (6i, 6ii, 6iii, 6iv) kraftschlüssig fixiert ist.

5. Messanordnung (1) nach einem der Ansprüche 3 oder 4, wobei die Fixierungseinrichtung (5) oder die Vorspanneinrichtung (8) eine Aussparung aufweist, in welcher eine Welle (9) der elektrischen Maschine (2) aufgenommen und/oder hindurchgeführt werden kann, wobei vorzugsweise eine Seite der elektrischen Maschine (2), auf welcher die Welle (9) austritt, der Fixierungseinrichtung (5) und/oder der Vorspanneinrichtung (8) zugewandt ist.

6. Messanordnung (1) nach einem der vorhergehenden Ansprüche, wobei die Drehachse (7) bei bestimmungsgemäßem Gebrauch der Messanordnung (1) wenigstens im Wesentlichen vertikal ausgerichtet ist.

7. Messanordnung (1) nach einem der vorhergehenden Ansprüche, wobei die Fixierungseinrichtung (5) oder die elektrische Maschine (2) ausschließlich durch das wenigstens eine Piezoelement (6i, 6ii, 6iii, 6iv) abgestützt wird.

8. Messanordnung (1) nach einem der vorhergehenden Ansprüche, wobei die Vorzugsrichtung des wenigstens einen Piezoelements (6i, 6ii, 6iii, 6iv) jeweils wenigstens im Wesentlichen tangential zu einer Drehrichtung der Welle ausgerichtet ist.

9. Messanordnung (1) nach einem der vorhergehenden Ansprüche, wobei das wenigstens eine Piezoelement (6i, 6ii, 6iii, 6iv) ein erstes Teilelement (6i-1, 6ii-1, 6iii-1, 6iv-1) und ein zweites Teilelement (6i-2, 6ii-2, 6iii-2, 6iv-2) aufweist, mittels welchen jeweils Scherkräfte messbar sind, wobei eine Vorzugsrichtung des ersten Teilelements (6i-1, 6ii-1, 6iii-1, 6iv-1) wenigstens im Wesentlichen senkrecht zu einer Vorzugsrichtung des zweiten Teilelements (6i-2, 6ii-2, 6iii-2, 6iv-2) ausgerichtet ist, wobei die beiden Teilelemente (6i-1, 6i-2; 6ii-1; 6ii-2; 6iii-1, 6iii-2; 6iv-1, 6iv-2) entlang ihrer Stirnseiten zueinander angeordnet sind.

10. Messanordnung (1) nach einem der vorhergehenden Ansprüche, wobei das wenigstens eine Piezoelement (6i, 6ii, 6iii, 6iv) ein erstes Teilelement (6i-1, 6ii-1, 6iii-1, 6iv-1) und/oder zweites Teilelement (6i-2, 6ii-2, 6iii-2, 6iv-2), mittels welchem oder welchen eine Scherkraft messbar ist, und ein drittes Teilelement (6i-3, 6ii-3, 6iii-3, 6iv-3), mittels welchem eine Druckkraft messbar ist, aufweist, wobei die Teilelemente (6i-1, 6i-2, 6i-3; 6ii-1; 6ii-2, 6ii-3; 6iii-1, 6iii-2, 6iii-3; 6iv-1, 6iv-2, 6iv-3) entlang ihrer Stirnseiten zueinander angeordnet sind.

11. Messanordnung (1) nach einem der vorhergehenden Ansprüche, wobei die Messvorrichtung (3) des Weiteren Mittel aufweist, welche eingerichtet sind, gewünschte Messgrößen, insbesondere ein Drehmoment um die Drehachse (7) und/oder Kräfte, welche parallel zu der Ebene wirken, unter Berücksichtigung eines jeweiligen Winkels zwischen der Vorzugsrichtung oder den Vorzugsrichtungen des wenigstens einen Piezoelements (6i, 6ii, 6iii, 6iv) und Tangenten an die Drehrichtung des Rotors (4) an dem Ort oder den Orten des wenigstens einen Piezoelements (6i, 6ii, 6iii, 6iv) zu bestimmen.

12. Messanordnung (1) nach einem der vorhergehenden Ansprüche, wobei die Messvorrichtung (3) des Weiteren Mittel aufweist, welche eingerichtet sind, gewünschte Messgrößen, insbesondere ein Drehmoment um die Drehachse und/oder Kräfte, welche parallel zu der Ebene wirken mittels eines, insbesondere linearen, Gleichungssystems anhand von Messungen des wenigstens eine Piezoelements (6i, 6ii, 6iii, 6iv) zu bestimmen.

13. Messanordnung (1) nach einem der Ansprüche 3 bis 12, wobei die Fixierungseinrichtung (5a, 5b) und die Vorspanneinrichtung (8a, 8b) zweiteilig ausgebildet sind und die Vorspanneinrichtung (8a, 8b) zwei Halbschalen (8a, 8b) aufweist, um die elektrische Maschine (2) aufzunehmen, wobei die Messvorrichtung (3) des Weiteren zweite Vorspannelemente aufweist, mittels welcher die beiden Halbschalen (8a, 8b) gegeneinander vorgespannt werden können, so dass zwischen der Vorspanneinrichtung (8a, 8b) und der elektrischen Maschine (2) ein Kraftschluss herstellbar ist.

14. Prüfstand mit einer Messanordnung nach einem der Ansprüche 1 bis 13.

15. Verfahren zum Bestimmen eines Verlustmoments einer elektrischen Maschine mit Rotor (4) mittels einer Messanordnung (1) nach einem der Ansprüche 1 bis 13, die folgenden Arbeitsschritte aufweisend:

erstes Betreiben (101) der Maschine (2) in der Weise, dass der Rotor (4) eine vordefinierte Drehzahl erreicht;
zweites Betreiben (102) der Maschine (2) im Leerlauf, wenn die vordefinierte Drehzahl erreicht ist, wobei ein Signal der Messvorrichtung (3), welches das axiale Moment an der Maschine (2) repräsentiert, überwacht wird;
Identifizieren (104) eines Sprungs in dem Signal; und
Bestimmen (106) des Betrags des Sprungs, wobei der Betrag das Verlustmoment der elektrischen Maschine (2) angibt.

## Claims

1. Measuring arrangement (1) having an electric machine (2) with a rotor (4) and a measuring device (3) for determining a loss torque of the electric machine (2), wherein the rotor (4) rotates freely and is therefore not loaded by an external load,
   **characterised in that**

   the measuring device (3) has a fixing device (5) and at least one piezo element (6i, 6ii, 6iii, 6iv), preferably at least three, in particular four, piezo elements, each with a preferred direction, wherein the fixing device (5) supports the at least one piezo element (6i, 6ii, 6iii, 6iv) and the electrical machine is mounted via the at least one piezo element (6i, 6ii, 6iii, 6iv) in such a way that at least shear forces between the electrical machine (2) and the fixing device (5) can be measured by means of the at least one piezo element (6i, 6ii, 6iii, 6iv), wherein the preferred direction or preferred directions are each parallel to or in a single plane, wherein an axis of rotation (7) of the rotor (4) intersects the plane at an angle between 45° and 135°, preferably between 85° and 95°, most preferably at least essentially perpendicularly.

2. Measuring arrangement (1) according to claim 1, wherein the measuring device (3) has more than one piezo element (6i, 6ii, 6iii, 6iv), wherein the piezo elements (6i, 6ii, 6iii, 6iv) are each arranged at different positions around the axis of rotation (7) of the rotor (4) of the electrical machine (2).

3. Measuring arrangement (1) according to claim 1 or 2, wherein the measuring device (2) further comprises a pretensioning device (8) and first pretensioning elements, wherein the at least one piezo element (6i, 6ii, 6iii, 6iv) between the fixing device (5) and the pretensioning device (8) can be pretensioned or is pretensioned by means of the first pretensioning elements in such a way that the at least one piezo element (6i, 6ii, 6iii, 6iv) is fixed in a force-locking manner, and wherein the electrical machine (2) is attached to the pretensioning device (8) in a rotationally fixed manner.

4. Measuring arrangement (1) according to one of claims 1 to 3, wherein the electrical machine (2) is fastened to the fixing device (5) and is supported by the at least one piezo element (6i, 6ii, 6iii, 6iv) in such a way that the at least one piezo element (6i, 6ii, 6iii, 6iv) is fixed in a force-locking manner.

5. Measuring arrangement (1) according to one of claims 3 or 4, wherein the fixing device (5) or the pretensioning device (8) has a recess in which a shaft (9) of the electrical machine (2) can be accommodated and/or guided through, wherein preferably one side of the electrical machine (2), on which the shaft (9) emerges, faces the fixing device (5) and/or the pretensioning device (8).

6. Measuring arrangement (1) according to one of the preceding claims, wherein the axis of rotation (7) is orientated at least essentially vertically when the measuring arrangement (1) is used as intended.

7. Measuring arrangement (1) according to one of the preceding claims, wherein the fixing device (5) or the electrical machine (2) is supported exclusively by the at least one piezo element (6i, 6ii, 6iii, 6iv).

8. Measuring arrangement (1) according to one of the preceding claims, wherein the preferred direction of the at least one piezo element (6i, 6ii, 6iii, 6iv) is in each case orientated at least essentially tangentially to a direction of rotation of the shaft.

9. Measuring arrangement (1) according to one of the preceding claims, wherein the at least one piezo element (6i, 6ii, 6iii, 6iv) has a first sub-element (6i-1, 6ii-1, 6iii-1, 6iv-1) and a second sub-element (6i-2, 6ii-2, 6iii-2, 6iv-2), by means of which shear forces can be measured in each case, wherein a preferred direction of the first sub-element (6i-1, 6ii-1, 6iii-1, 6iv-1) is aligned at least essentially perpendicular to a preferred direction of the second sub-element (6i-2, 6ii-2, 6iii-2, 6iv-2), wherein the two sub-elements (6i-1, 6i-2; 6ii-1; 6ii-2; 6iii-1, 6iii-2; 6iv-1, 6iv-2) are arranged along their front sides relative to one another.

10. Measuring arrangement (1) according to one of the preceding claims, wherein the at least one piezo element (6i, 6ii, 6iii, 6iv) comprises a first sub-element (6i-1, 6ii-1, 6iii-1, 6iv-1) and/or second sub-element (6i-2, 6ii-2, 6iii-2, 6iv-2), by means of which a shear force can be measured, and a third sub-element (6i-3, 6ii-3, 6iii-3, 6iv-3), by means of which a compressive force can be measured, wherein the sub-elements (6i-1, 6i-2, 6i-3; 6ii-1; 6ii-2, 6ii-3; 6iii-1, 6iii-2, 6iii-3; 6iv-1, 6iv-2, 6iv-3) are arranged along their front sides relative to one another.

11. Measuring arrangement (1) according to one of the preceding claims, wherein the measuring device (3) further comprises means which are set up to measure desired measured variables, in particular a torque about the axis of rotation (7) and/or forces which act parallel to the plane, taking into account a respective angle between the preferred direction or directions of the at least one piezo element (6i, 6ii, 6iii, 6iv) and tangents to the direction of rotation of the rotor (4) at the location or locations of the at least one piezo element (6i, 6ii, 6iii, 6iv).

12. Measuring arrangement (1) according to one of the preceding claims, wherein the measuring device (3) further comprises means which are set up to determine desired measured variables, in particular a torque about the axis of rotation and/or forces which act parallel to the plane by means of a, in particular linear, equation system on the basis of measurements of the at least one piezo element (6i, 6ii, 6iii, 6iv).

13. Measuring arrangement (1) according to one of claims 3 to 12, wherein the fixing device (5a, 5b) and the pretensioning device (8a, 8b) are formed in two parts and the pretensioning device (8a, 8b) has two half-shells (8a, 8b) in order to accommodate the electrical machine (2), wherein the measuring device (3) further comprises second pretensioning elements, by means of which the two half-shells (8a, 8b) can be pretensioned against each other so that a frictional connection can be produced between the pretensioning device (8a, 8b) and the electrical machine (2).

14. Test bench with a measuring arrangement according to one of claims 1 to 13.

15. Method for determining a torque loss of an electric machine with a rotor (4) by means of a measuring arrangement (1) according to one of claims 1 to 13, comprising the following steps:

first operating (101) the machine (2) in such a way that the rotor (4) reaches a predefined speed;
second operating (102) the machine (2) at idle when the predefined speed is reached, wherein a signal of the measuring device (3) representing the axial torque on the machine (2) is monitored;
identifying (104) a jump in the signal; and
determining (106) the magnitude of the jump, the magnitude indicating the loss torque of the electrical machine (2).

**Revendications**

1. Dispositif de mesure (1) comportant une machine électrique (2) avec un rotor (4) et un appareil de mesure (3) pour déterminer un couple de perte de la machine électrique (2), dans lequel le rotor (4) tourne librement et n'est donc pas sollicité par une charge externe,
   **caractérisé par le fait que**

l'appareil de mesure (3) comporte un dispositif de fixation (5) et au moins un élément piézoélectrique (6i, 6ii, 6iii, 6iv), de préférence au moins trois, en particulier quatre, éléments piézoélectriques, chacun ayant une direction préférentielle,
dans lequel le dispositif de fixation (5) supporte au moins un élément piézoélectrique (6i, 6ii, 6iii, 6iv) et la machine électrique est montée via au moins un élément piézoélectrique (6i, 6ii, 6iii, 6iv) de telle sorte qu'au moins les forces de cisaillement entre la machine électrique (2) et le dispositif de fixation (5) peuvent être mesurées au moyen d'au moins un élément piézoélectrique (6i, 6ii, 6iii, 6iv),
dans lequel la ou les directions préférées sont chacune parallèles à ou situées dans un seul plan
dans lequel un axe de rotation (7) du rotor (4) coupe le plan à un angle compris entre 45° et 135°, de préférence entre 85° et 95°, de préférence au moins sensiblement perpendiculaire.

2. Dispositif de mesure (1) selon la revendication 1, dans lequel l'appareil de mesure (3) comprend plus d'un élément piézoélectrique (6i, 6ii, 6iii, 6iv), les éléments piézoélectriques (6i, 6ii, 6iii, 6iv) étant respectivement disposés à différentes positions autour de l'axe de rotation (7) du rotor (4) de la machine électrique (2).

3. Dispositif de mesure (1) selon la revendication 1 ou 2, dans lequel le dispositif de mesure (2) comprend en outre un dispositif de précontrainte (8) et des premiers éléments de précontrainte, dans lequel le au moins un élément piézoélectrique (6i, 6ii, 6iii, 6iv) entre le dispositif de fixation (5) et le dispositif de précontrainte (8) peut être précontraint ou est précontraint au moyen des premiers éléments de précontrainte de telle sorte que le au moins un élément piézoélectrique (6i, 6ii, 6iii, 6iv) est fixé par adhérence, et dans lequel la machine électrique (2) est fixée au dispositif de précontrainte (8) de manière à résister à la rotation.

4. Dispositif de mesure (1) selon l'une des revendications 1 à 3, dans lequel la machine électrique (2) est fixée au dispositif de fixation (5) et est supportée par le au moins un élément piézoélectrique (6i, 6ii, 6iii, 6iv) de telle sorte que le au moins un élément piézoélectrique (6i, 6ii, 6iii, 6iv) est fixé par adhérence.

5. Dispositif de mesure (1) selon l'une des revendications 3 ou 4, dans lequel le dispositif de fixation (5) ou le dispositif de précontrainte (8) présente un évidement dans lequel un arbre (9) de la machine électrique (2) peut être reçu et/ou traversé, de préférence un côté de la machine électrique (2) sur lequel l'arbre (9) sort étant tourné vers le dispositif de fixation (5) et/ou le dispositif de précontrainte (8).

6. Dispositif de mesure (1) selon l'une des revendications précédentes, dans lequel l'axe de rotation (7) est orienté au moins sensiblement verticalement lorsque le dispositif de mesure (1) est utilisé conformément à sa destination.

7. Dispositif de mesure (1) selon l'une des revendications précédentes, dans lequel le dispositif de fixation (5) ou la machine électrique (2) est supporté(e) exclusivement par ledit au moins un élément piézoélectrique (6i, 6ii, 6iii, 6iv).

8. Dispositif de mesure (1) selon l'une des revendications précédentes, dans lequel la direction préférentielle dudit au moins un élément piézoélectrique (6i, 6ii, 6iii, 6iv) est respectivement orienté au moins sensiblement tangentiellement à un sens de rotation de l'arbre.

9. Dispositif de mesure (1) selon l'une des revendications précédentes, dans lequel le au moins un élément piézoélectrique (6i, 6ii, 6iii, 6iv) présente un premier élément partiel (6i-1, 6ii-1, 6iii-1, 6iv-1) et un deuxième élément partiel (6i-2, 6ii-2, 6iii-2, 6iv-2), au moyen desquels des forces de cisaillement peuvent être mesurées respectivement, dans lequel une direction préférentielle du premier élément partiel (6i-1, 6ii-1, 6iii-1, 6iv-1) étant orientée au moins sensiblement perpendiculairement à une direction préférentielle du deuxième élément partiel (6i-2, 6ii-2, 6iii-2, 6iv-2), dans lequel les deux éléments partiels (6i-1, 6i-2 ; 6ii-1 ; 6i-2 ; 6iii-1, 6iii-2 ; 6iv-1, 6iv-2) sont disposés l'un par rapport à l'autre le long de leurs faces frontales.

10. Dispositif de mesure (1) selon l'une des revendications précédentes, dans lequel le au moins un élément piézoélectrique (6i, 6ii, 6iii, 6iv) comprend un premier sous-élément (6i-1, 6ii-1, 6iii-1, 6iv-1) et/ou un deuxième sous-élément (6i-2, 6ii-2, 6iii-2, 6iv-2), au moyen duquel ou desquels une force de cisaillement peut être mesurée, et un troisième élément partiel (6i-3, 6ii-3, 6iii-3, 6iv-3), au moyen duquel une force de compression peut être mesurée, dans lequel les éléments partiels (6i-1, 6i-2, 6i-3 ; 6ii-1 ; 6ii-2, 6ii-3 ; 6iii-1, 6iii-2, 6iii-3 ; 6iv-1, 6iv-2, 6iv-3) sont disposés les uns par rapport aux autres le long de leurs faces frontales.

11. Dispositif de mesure (1) selon l'une des revendications précédentes, dans lequel l'appareil de mesure (3) comporte en outre des moyens agencés pour mesurer des grandeurs souhaitées, en particulier un couple autour de l'axe de rotation (7) et/ou des forces agissant parallèlement au plan, en tenant compte d'un angle respectif entre la ou les directions préférentielles du au moins un élément piézoélectrique (6i, 6ii, 6iii, 6iv) et des tangentes au sens de rotation du rotor (4) à l'endroit ou aux endroits du au moins un élément piézoélectrique (6i, 6ii, 6iii, 6iv).

12. Dispositif de mesure (1) selon l'une des revendications précédentes, dans lequel l'appareil de mesure (3) comporte en outre des moyens qui sont agencés pour déterminer des grandeurs de mesure souhaitées, en particulier un couple autour de l'axe de rotation et/ou des forces qui agissent parallèlement au plan, au moyen d'un système d'équations, en particulier linéaire, à l'aide de mesures du au moins un élément piézoélectrique (6i, 6ii, 6iii, 6iv).

13. Dispositif de mesure (1) selon l'une des revendications 3 à 12, dans lequel le dispositif de fixation (5a, 5b) et le dispositif de précontrainte (8a, 8b) sont réalisés en deux parties et le dispositif de précontrainte (8a, 8b) présente deux demi-coques (8a, 8b) pour recevoir la machine électrique (2), l'appareil de mesure (3) présentant en outre des deuxièmes éléments de précontrainte au moyen desquels les deux demi-coques (8a, 8b) peuvent être précontraintes l'une contre l'autre, de sorte qu'une adhérence peut être établie entre le dispositif de précontrainte (8a, 8b) et la machine électrique (2).

14. Banc d'essai avec un dispositif de mesure selon l'une des revendications 1 à 13.

15. Procédé de détermination d'un couple de perte d'une machine électrique à rotor (4) au moyen d'un dispositif de mesure (1) selon l'une des revendications 1 à 13, comprenant les étapes suivantes :

premier fonctionnement (101) de la machine (2) de manière que le rotor (4) atteigne une vitesse de rotation prédéfinie ;
faire fonctionner une deuxième fois (102) la machine (2) au ralenti lorsque la vitesse prédéfinie est atteinte, dans lequel en surveillant un signal d'appareil de mesure (3) représentant le moment axial sur la machine (2) ;
identifier (104) un saut dans le signal ; et
déterminer (106) l'amplitude du saut, l'amplitude étant indicative du couple de perte de la machine électrique (2).

Fig. 1

Fig. 2

Fig. 3

Fig. 4

Fig. 5

Fig. 6

Fig. 7

Fig. 8

Fig. 9

101

102

100

103

104

105

106

Fig. 10

1001 1002 1000

1003 1004

1005 1006

Fig. 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- CN 115615597 A
- WO 2018046296 A1
- WO 2019144171 A1
- WO 2019144172 A1